# EUROPÄISCHE PATENTSCHRIFT

(11) **EP 2 936 074 B1**
(45) Veröffentlichungstag und Bekanntmachung des Hinweises auf die Patenterteilung: **10.05.2017**
(21) Anmeldenummer: 13798670.9
(22) Anmeldetag: 29.11.2013
(51) Int. Cl.: G01D 18/00, G01D 11/24, G01R 1/04, G01R 33/09, H01L 23/544, H05K 1/02, H05K 5/00, H05K 5/06, H05K 3/28

(54) **SENSOR ZUM AUSGEBEN EINES ELEKTRISCHEN SIGNALS BASIEREND AUF EINER ERFASSTEN PHYSIKALISCHEN GRÖSSE**
SENSOR FOR OUTPUTTING AN ELECTRIC SIGNAL ON THE BASIS OF A DETECTED PHYSICAL VARIABLE
DÉTECTEUR DESTINÉ À ÉMETTRE UN SIGNAL ÉLECTRLIQUE SUR LA BASE D'UNE GRANDEUR PHYSIQUE DÉTECTÉE

(30) Priorität: 20.12.2012 DE 102012224102
(43) Veröffentlichungstag der Anmeldung: 28.10.2015
(73) Patentinhaber: Continental Teves AG&Co. Ohg, 60488 Frankfurt (DE)
(72) Erfinder: SCHILLINGER, Jakob, 85080 Gaimersheim (DE); HUBER, Dietmar, 63322 Rödermark (DE); BIEBRICHER, Lothar, 61440 Oberursel (DE); GOLL, Manfred, 63695 Glauburg 2 (DE); BENNER, Marco, 35216 Biedenkopf-Wallau (DE)
(86) Internationale Anmeldenummer: PCT/EP2013/075186
(87) Internationale Veröffentlichungsnummer: WO 2014/095314

(56) Entgegenhaltungen:
- WO-A1-2010/037810
- WO-A1-2011/043488
- DE-A1- 4 237 870
- US-A1- 2002 170 897

## Beschreibung

Die Erfindung betrifft einen Sensor zum Ausgeben eines elektrischen Signals basierend auf einer erfassten physikalischen Größe und ein Verfahren zum Herstellen eines Sensors zum Ausgeben eines elektrischen Signals basierend auf einer erfassten physikalischen Größe.

Aus der WO 2010 / 037 810 A1 ist ein Sensor zum Ausgeben eines elektrischen Signals basierend auf einer erfassten physikalischen Größe bekannt. Der Sensor weist eine Messschaltung auf, die in einem Schaltungsgehäuse eingehaust ist. Aus der DE 4237870 A1 ist ein ähnlicher Sensor bekannt. Es ist Aufgabe der Erfindung, den bekannten Sensor zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Sensor zum Ausgeben eines elektrischen Signals basierend auf einer erfassten physikalischen Größe eine Messschaltung, die in einem Schaltungsgehäuse eingehaust und über einen elektrischen Signalanschluss mit einer externen Schaltung kontaktierbar ist, und einen das Schaltungsgehäuse umgebenden Schutzkörper aus einer Schutzmasse mit einer Öffnung, über die ein Teil des Schaltungsgehäuses freigelegt ist. Dabei weist das Schaltungsgehäuse auf seiner Oberfläche ein Formelement auf, das von der Schutzmasse umgeben ist.

Dem angegebenen Sensor liegt die Überlegung zugrunde, dass die Schutzmasse und das Schaltungsgehäuse Wärmeausdehnungseffekten unterworfen sind, aufgrund derer sich die Schutzmasse des Schutzkörpers vom Schaltungsgehäuse lösen und so einen Spalt zwischen dem Schutzkörper und dem Schaltungsgehäuse ausbilden könnte. In diesen Spalt könnten Feuchtigkeit und andere Reagenzien eindringen, die nach einer längeren Betriebsdauer des Sensors zu einer Korrosion oder einer Migration des Sensors im Bereich des Signalanschlusses führen und so den Signalanschluss entsprechend unterbrechen oder kurzschließen könnte.

Diese Überlegung zugrunde gelegt ist es Idee des angegebenen Sensors, den Weg im Spalt für die oben genannte Feuchtigkeit und Reagenzien so lang wie möglich auszugestalten. Dazu sind auf der Oberfläche des Schaltungsgehäuses mindestens zwei umfänglich um das Schaltungsgehäuse verlaufende Rippen ausgebildet, die von der Schutzmasse des Schutzkörpers umgeben sind. Das heißt, dass das Schaltungsgehäuse und der Schutzkörper ineinander verzahnt werden und so den oben genannten Spalt verlängern. Die Feuchtigkeit und den Reagenzien müssen daher einen längeren Weg durch den Spalt zurücklegen, bevor die den Signalanschluss erreichen. Auf diese Weise kann die Betriebsdauer des angegebenen Sensors bis zur oben genannten Korrosion oder Migration gesteigert werden, so dass eine Ausfallrate des angegebenen Sensors gesenkt werden kann. Dabei verläuft das Formelement bzw. verlaufen die Rippen umfänglich um das Schaltungsgehäuse. Hier liegt die Überlegung zugrunde, dass der oben genannte Spalt nur deshalb zustande kommt, weil sich das Schaltungsgehäuse und der Schutzkörper wie bereits erwähnt mit unterschiedlichen Ausdehnungskoeffizienten ausdehnen. Die vorliegende Weiterbildung nutzt diese Tatsache, dass sich das Schaltungsgehäuse und der Schutzkörper aufgrund des Formelementes ineinander verzahnen. Das heißt, dass einer der beiden Verzahnungspartner das Schaltungsgehäuse oder der Schutzkörper eine Ausnehmung aufweisen und der entsprechend andere der beiden Verzahnungspartner einen Vorsprung, der im Wesentlichen formschlüssig in der Ausnehmung aufgenommen ist. Da der Schutzkörper einen höheren Ausdehnungskoeffizienten aufweist, als das Schaltungsgehäuse, wird er sich bei Kälte gegenüber dem Schaltungsgehäuse zusammenziehen und sein Verzahnungspartner wird den Verzahnungspartner am Schaltungsgehäuse radial verschließen. Bei Wärme wird sich der Schutzkörper gegenüber dem Schaltungsgehäuse ausdehnen und sein Verzahnungspartner wird den Verzahnungspartner am Schaltungsgehäuse axial verschließen. Da das Formelement / die Rippen als Verzahnungspartner am Schaltungsgehäuse daher umfänglich um dieses herum verläuft / verlaufen, kann der obige Spalt unabhängig von Wärme und Kälte in der zuvor beschriebenen Weise zuverlässig verschlossen werden.

Zwar kann das Formelement prinzipiell eine Vertiefung im Schaltungsgehäuse sein, erfindungsgemäss sind jedoch mindestens zwei Rippen vorgesehen, die fertigungstechnisch an das Schaltungsgehäuse besonders einfach anzubringen und in einfacher Weise umspritzt oder umgossen werden können. Dabei weist die Schutzmasse einen Ausdehnungskoeffizienten auf, der größer ist, als ein Ausdehnungskoeffizient des Schaltungsgehäuses, wodurch in der oben beschriebenen Weise erreicht werden kann, dass der Spalt zwischen dem Schaltungsgehäuse und dem Schutzkörper unabhängig von Kälte oder Wärme zuverlässig verschlossen werden kann.

In einer besonders bevorzugten Weiterbildung des angegebenen Sensors weist eine Wand des Formelements / der Rippen einen Steigungswinkel zur Oberfläche des Schaltungsgehäuses auf, der in einem Bereich zwischen 70° und 88° liegt. Mit diesem Steigungswinkel ist eine besonders effektive wärme- und kälteunabhängige Abdichtung des oben genannten Spaltes in der beschriebenen Weise gegeben.

In einer anderen Weiterbildung des angegebenen Sensors ist die Schutzmasse um das Schaltungsgehäuse spritzbar oder vergießbar, wobei deren Schrumpfung beim Aushärten nach dem Spritzen oder Vergießen kleiner gewählt ist, als eine Schrumpfung beim Abkühlen von einer Arbeitstemperatur des Sensors auf eine Erstarrungstemperatur der Schutzmasse. Auf diese Weise ist sichergestellt, dass sich die Schutzmasse auch beim Erstarren an einen Teil des Formelementes des Schaltungsgehäuses anlegt und den Spalt so zuverlässig in der oben beschriebenen Weise verschließt.

In einer noch anderen Weiterbildung des angegebenen Sensors ist wenigstens ein Teil der Oberfläche des Schaltungsgehäuses im Kontaktbereich mit der Schutzmasse aktiviert. Unter einer Aktivierung der Oberfläche des Schaltungsgehäuses soll nachstehend eine teilweise Zerstörung der molekularen Struktur der Oberfläche des Schaltungsgehäuses verstanden werden, so dass an der Oberfläche des Schaltungsgehäuses freie Radikale entstehen. Diese freien Radikale sind in der Lage, chemische und/oder physische Verbindungen mit der Schutzmasse einzugehen, so dass diese sich nicht mehr von der Oberfläche des Schaltungsgehäuses lösen kann. Auf diese Weise kann die Entstehung des oben genannten Spaltes fast vollständig vermieden werden. Tritt er dennoch auf, so verhindern die zuvor genannten Maßnahmen wirksam, dass die oben genannte Feuchtigkeit und Reagenzien durch den Spalt zum Signalanschluss des Sensors gelangen.

Die Schutzmasse kann dabei ein polares Material, wie Polyamid umfassen. Das polare Polyamid kann sich in einer dem Fachmann bekannten Weise physikalisch mit der aktivierten Oberfläche des Schaltungsgehäuses verbinden und so den obigen Spalt verschließen. Es sind weitere Verbindungen möglich, die im Schmelzzustand der Schutzmasse eine polare Oberfläche aufweisen und dadurch eine Verbindung mit der aktivierten Oberfläche des Schaltungsgehäuses eingehen. Diese eingegangene Verbindung bleibt nach der Erstarrung der geschmolzenen Schutzmasse erhalten.

In einer zusätzlichen Weiterbildung des angegebenen Sensors ist wenigstens ein Teil der Oberfläche des Schaltungsgehäuses im Kontaktbereich mit der Schutzmasse aufgeraut, so dass die wirksame aktivierte Oberfläche vergrößert und die Haftwirkung zwischen Schaltungsgehäuse und Schutzmasse gesteigert wird.

In einer besonderen Weiterbildung des angegebenen Sensors ist der aufgeraute Teil der Oberfläche des Schaltungsgehäuses mit einem Laser aufgeraut. Mit dem Laser kann die Oberfläche des Schaltungsgehäuses nicht nur aktiviert werden, durch den Laser werden von der Oberfläche des Schaltungsgehäuses auch eventuell vorhandene Formtrennmittel abgetragen, die eine Haftung zwischen dem Schaltungsgehäuse und der Schutzmasse unterdrücken könnten.

Alternativ kann der Laser aber auch nur zum Aufrauen der Oberfläche verwendet werden. Die Aktivierung kann dann beispielsweise mit einem Plasma durchgeführt werden.

Gemäß einem weiteren Aspekt der Erfindung umfasst ein Verfahren zur Herstellung eines Sensors zum Ausgeben eines elektrischen Signals basierend auf einer erfassten physikalischen Größe die Schritte, die in Anspruch 7 definiert sind. Durch ein Aufrauen der Oberfläche nach einer bevorzugten Weiterbildung werden zumindest kleine Formelemente geschaffen, mit denen das Eindringen von Feuchtigkeit und Reagenzien in den Spalt weiter hinausgezögert werden kann, um die Lebensdauer des hergestellten Sensors zu erhöhen.

Besonders bevorzugt erfolgt das Aufrauen dabei mittels eines Lasers.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 in einer Schnittansicht eine Schaltung mit einem Sensor,
Fig. 2 in einer schematischen Ansicht den einen Teil des Sensors aus Fig. 1,
Fig. 3 einen Ausschnitt aus dem Sensor aus Fig. 2, und
Fig. 4 einen weiteren Ausschnitt aus dem Sensor aus Fig. 2 zeigen.

In den Figuren werden gleiche technische Elemente mit gleichen Bezugszeichen versehen und nur einmal beschrieben.

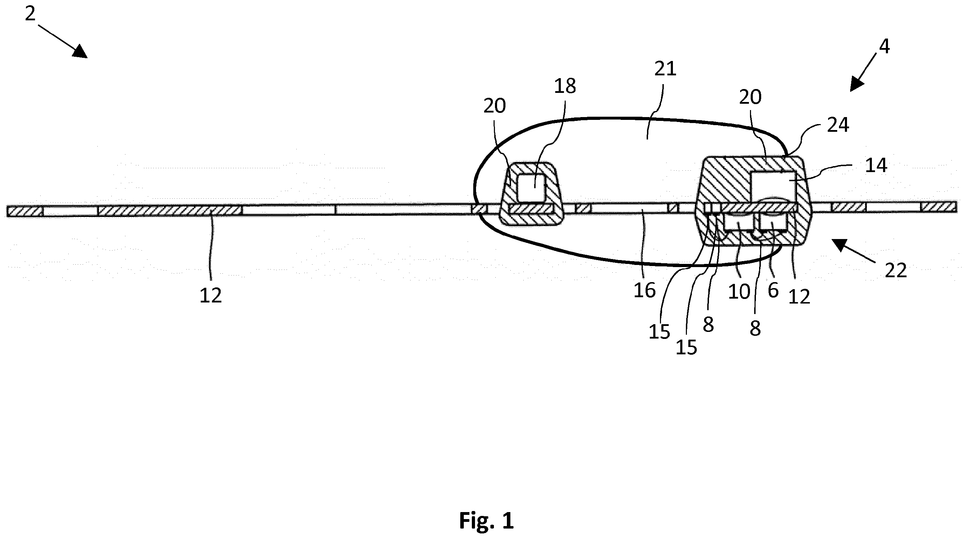

Es wird auf Fig. 1 Bezug genommen, die in einer Schnittansicht eine Schaltung 2 mit einem Sensor 4 zeigt.

Der Sensor 4 ist in der vorliegenden Ausführung als Magnetfeldsensor ausgeführt, wie er beispielsweise in Drehzahlsensoren zur Erfassung eines gerasterten Magnetfeldes zum Einsatz kommt. Der Magnetfeldsensor 4 weist einen Messaufnehmer 6, wie beispielsweise einen Hallsensor oder einen an sich bekannten magnetoresistiven Messaufnehmer und eine mit dem Messaufnehmer 6 über Bonddrähte 8 verbundene Auswerteschaltung 10 auf. Dabei können der Messaufnehmer 6 und seine Auswerteschaltung 10 in einem gemeinsamen Bauteil zusammengefasst sein. Der Messaufnehmer 6 und die Auswerteschaltung 10 sind auf einem Leadframe 12 gehalten, wobei die Auswerteschaltung 10 über Bonddrähte 8 mit dem Leadframe elektrisch kontaktiert ist. Auf einer dem Messaufnehmer 6 gegenüberliegenden Seite des Leadframes 12 kann optional ein Magnet 14 gehalten sein, der in einer dem Fachmann bekannten Weise einen Arbeitspunkt für den Messaufnehmer 6 festlegt, wenn dies für den Einsatz wie bei einigen magnetoresistiven Messaufnehmern notwendig ist.

Über die Bonddrähte 8 können Messsignale aus dem Messaufnehmer 6, wie beispielsweise eine Hallspannung aus einem als Hallsensor ausgebildeten Messaufnehmer 6 übertragen werden. Die Messsignale können in der Auswerteschaltung 10 gefiltert, gewandelt und codiert werden. Die durch die Auswerteschaltung 10 ausgewerteten Messsignale können dann über die Bonddrähte zwischen der Auswerteschaltung 10 und dem Leadframe 12 auf Leiterbahnen 15 des Leadframes 12 übertragen werden, die die ausgewerteten Messsignale dann beispielsweise an eine Motorsteuerung in einem Fahrzeug weiterleiten können.

Die Leiterbahnen 15 auf des Leadframes 12 sind über Ausnehmungen 16 strukturiert und können neben dem Magnetfeldsensor 4 weitere elektrische Bauelemente wie beispielsweise ein Schutzkondensator 18 für den Magnetfeldsensor 4 tragen.

Die einzelnen elektrischen Bauelemente 4, 18 auf dem Leadframe 12 können je von einer Bauteilschutzmasse 20 umgeben sein. Diese Bauteilschutzmasse 20 dient den elektrischen einzelnen Bauelementen 4, 18 als Bauteilschutzkörper, der die elektrischen Bauelemente 4, 18 beispielsweise bei der Montage auf dem Leadframe 12 vor einem unbeabsichtigten Berühren schützt.

Die Gesamtheit aller elektrischen Bauelemente 4, 18 ist in der vorliegenden Ausführung von einer Schaltungsschutzmasse 21 umgeben, um die basierend auf dem Leadframe 12, den Leiterbahnen 15 und den elektrischen Bauelementen 4, 18 ausgebildete Schaltung vor Schmutz und Feuchtigkeit zu schützen und ihre Lebensdauer zu steigern.

Dabei sollte jedoch zur Herstellung des Schaltungsschutzkörpers so wenig wie möglich Schaltungsschutzmasse 21 verwendet werden, weshalb es günstig wäre, einen Teil der Bauteilschutzmasse 20 der elektrischen Bauelemente 4, 18 nicht mit der Schaltungsschutzmasse 21 zu bedecken.

Wird beispielsweise ein Teil der Bauteilschutzmasse 20 des Magnetfeldsensors 4 nicht mit der Schaltungsschutzmasse 21 bedeckt, dann weist der durch die Schaltungsschutzmasse 20 ausgebildete Schaltungsschutzkörper eine Öffnung 22 auf.

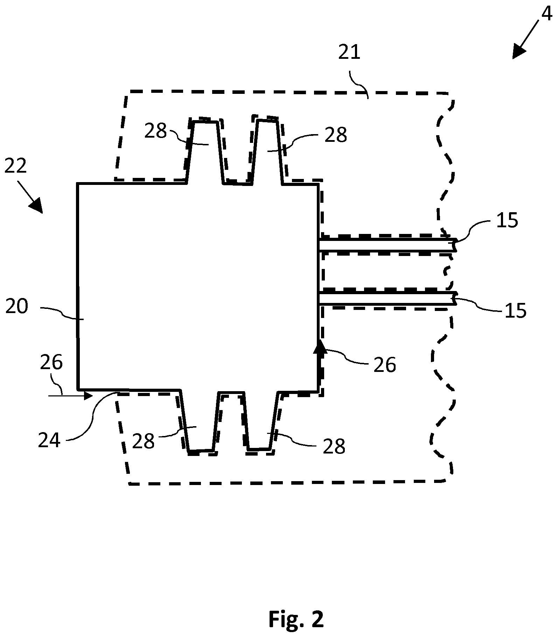

Diese Öffnung 22 ist kann jedoch problematisch sein, da der Magnetfeldsensor 4 prinzipbedingt Temperaturschwankungen ausgesetzt ist, die zu unterschiedlichen Wärmeausdehnungen der Bauteilschutzmasse 20 und der Schaltungsschutzmasse 21 führen können. Umfasst die Bauteilschutzmasse 20 beispielsweise ein Duroplastmaterial, wie beispielsweise einem Epoxidharz und wird von einem Thermoplast als Schaltungsschutzmasse 21, wie beispielsweise einem Polyamid umhüllt, dann dehnt sich das Polyamid aufgrund eines höheren Wärmeausdehnungskoeffizienten schneller aus, als das Epoxidharz. In diesem Fall könnte sich die Schaltungsschutzmasse 21 von der Bauteilschutzmasse 20 lösen, wodurch sich zwischen beiden Elementen ein Spalt 24 ausbildet, in den beispielsweise in Fig. 2 angedeutete Feuchtigkeit 26 eindringen kann.

Dies soll anhand von Fig. 2 näher erläutert werden, die in einer schematischen Ansicht einen Teil des Magnetfeldsensors 4 aus Fig. 1 zeigt.

Die Feuchtigkeit 26 könnte sich wie in Fig. 2 angedeutet durch den Spalt 24 hin zu den Bonddrähten 8 und den Leiterbahnen 15 bewegen, von denen in Fig. 2 nur die Leiterbahnen 15 gezeigt sind. Dies könnte die Bonddrähte 8 und die Leiterbahnen korrodieren und so unterbrechen, oder migrieren und so gegeneinander kurzschließen. In beiden Fällen wäre der Magnetfeldsensor 8 funktionsuntüchtig und würde ausfallen.

Um das Erreichen der Feuchtigkeit 26 an den Bonddrähten 8 und Leiterbahnen 15 soweit wie möglich hinauszuzögern, sind in der vorliegenden Ausführung an der Bauteilschutzmasse 20 Formelemente in Form von Rippen 28 ausgebildet, die die Feuchtigkeit 26 in dem Spalt 24 umfließen muss. Auf diese Weise wird für die Feuchtigkeit 26 der Weg durch den Spalt 24 verlängert, was die oben genannten Folgen der Feuchtigkeit 26 an den Bonddrähten 8 und den Leiterbahnen 15 hinauszögert und der Magnetfeldsensor 8 so länger betriebsfähig bleiben kann.

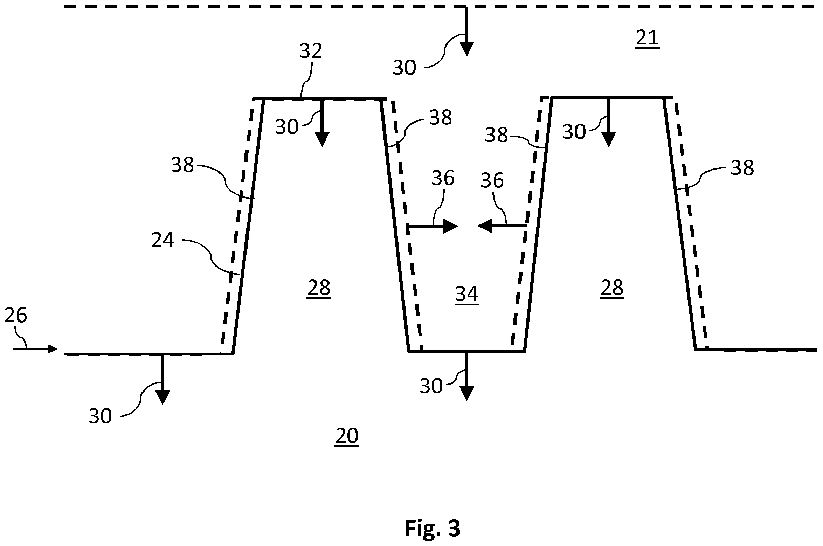

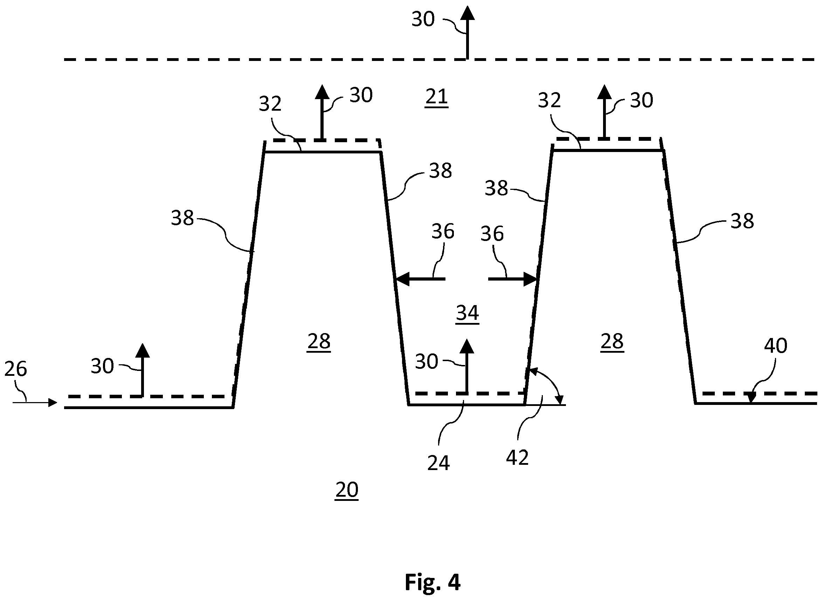

Die Rippen 28 können beim Aufbringen der Schaltungsschutzmasse 21 auf die Bauteilschutzmasse 20 in einfacher Weise umspritzt werden. Dabei verlaufen die Rippen 28 umfänglich um den Magnetfeldsensor 4. Auf diese Weise kann die Dichtwirkung durch die Rippen 28 weiter gesteigert werden, was nachstehend anhand der Fig. 3 und 4 näher erläutert werden soll.

Anhand Fig. 3 soll der Spalt 24 zwischen der Bauteilschutzmasse 20 und der Schaltungsschutzmasse 21 beschrieben werden, wenn der Magnetfeldsensor 4 einer sehr niedrigen Temperatur, ausgesetzt ist, die beispielsweise deutlich niedriger ist, als eine Betriebstemperatur des Magnetfeldsensors 4.

In dem Magnetfeldsensor 4 schrumpft die den Schaltungsschutzkörper bildende Schaltungsschutzmasse 21 gegenüber der Bauteilschutzmasse 20 schneller. Das heißt, dass sich die Bauteilschutzmasse 21 in einer radialen Richtung 30 auf die Bauteilschutzmasse 20 zubewegt, das heißt, sie klemmt die den durch die Bauteilschutzmasse 20 gebildeten Bauteilschutzkörper zwischen sich ein. Somit legt sich die Schaltungsschutzmasse 21 auf die radialen Spitzen 32 der Rippen 28 und verschließt so den Spalt 24 an dieser Stelle. Zwar zieht sich eine zwischen den Rippen 28 eingreifende Zunge 34 aus der Schaltungsschutzmasse 21 in axialer Richtung 36 zusammen und öffnet damit den Spalt 24 an den axialen Wänden 38 der Rippen 28, es existiert jedoch kein durchgehender Spalt 24 zu den Leiterbahnen 15 und den Bonddrähten 8, so dass dorthin auch keine Feuchtigkeit 26 eindringen kann.

In Fig. 4 sind die Verhältnisse gezeigt, in denen der Magnetfeldsensor 4 einer sehr hohen Temperatur, ausgesetzt ist, die beispielsweise im Bereich der Betriebstemperatur des Magnetfeldsensors 4 liegen kann.

In diesem Fall dehnt sich zwar die gesamte Schaltungsschutzmasse 21 aus und löst sich in radialer Richtung 30 beispielsweise von den radialen Spitzen 32 der Rippen 28, jedoch dehnt sich auch gleichzeitig die Zunge 34 in axialer Richtung 36 aus und verschließt so den Spalt 24 an den axialen Wänden 38 der Rippen, so dass auch in diesem Fall kein durchgehender Spalt 24 bis zu den Bonddrähten 8 vorhanden ist.

Um in diesem Falle eine besonders gute Verschlusswirkung des Spaltes 24 an den axialen Wänden 38 der Rippen 28 zu erzielen, sollten die axialen Wände 38 gegenüber einer radialen Oberfläche 40 des durch die Bauteilschutzmasse 20 gebildeten Bauteilschutzkörpers mit einem Steigungswinkel zwischen 70° und 88° geneigt sein.

Zur Verbesserung der Haftwirkung zwischen der Schaltungsschutzmasse 21 und der Bauteilschutzmasse 20 können weitere Maßnahmen ergriffen werden. So kann beispielsweise die gesamte Oberfläche des durch die Bauteilschutzmasse 20 gebildeten Schaltungsschutzkörpers wie in der WO 2010 / 037 810 A1 aktiviert werden, so dass die als Polyamid ausgebildete Schaltungsschutzmasse 21 besser an der Oberfläche des durch die Bauteilschutzmasse 20 gebildeten Schaltungsschutzkörpers haftet. Details dazu können der genannten Druckschrift entnommen werden.

Ferner kann die Aktivierung der Oberfläche des durch die Bauteilschutzmasse 20 gebildeten Schaltungsschutzkörpers mit einem Laser durchgeführt werden, wodurch die Oberfläche des durch die Bauteilschutzmasse 20 gebildeten Schaltungsschutzkörpers weiter vergrößert und die Haftbedingungen für die Schaltungsschutzmasse 21 am durch die Bauteilschutzmasse 20 gebildeten Schaltungsschutzkörper weiter verbessert werden.

## Patentansprüche

1. Sensor (4) zum Ausgeben eines elektrischen Signals basierend auf einer erfassten physikalischen Größe, umfassend:
- eine Messschaltung (6, 10), die in einem Schaltungsgehäuse (20) eingehaust und über einen elektrischen Signalanschluss (8) mit einer externen Schaltung (12) kontaktierbar ist, und
- einen das Schaltungsgehäuse (20) umgebenden Schutzkörper aus einer Schutzmasse (21) mit einer Öffnung (22), über die ein Teil des Schaltungsgehäuses (20) freigelegt ist,
- wobei das Schaltungsgehäuse (20) auf seiner Oberfläche mindestens zwei umfänglich um das Schaltungsgehäuse (20) verlaufende Rippen (28) aufweist, die von der Schutzmasse (21) umgeben sind, und
- wobei die Schutzmasse (21) einen Ausdehnungskoeffizienten aufweist, der größer ist als ein Ausdehnungskoeffizient des Schaltungsgehäuses (20).

2. Sensor (4) nach Anspruch 1, wobei eine Wand (38) der Rippen (28) einen Steigungswinkel (42) zur Oberfläche (40) des Schaltungsgehäuses (20) in einem Bereich zwischen 70° und 88° aufweist.

3. Sensor (4) nach einem der vorstehenden Ansprüche, wobei die Schutzmasse (21) um das Schaltungsgehäuse (20) spritzbar oder vergießbar ist, wobei deren Schrumpfung beim Aushärten nach dem Spritzen oder Vergießen kleiner gewählt ist, als eine Schrumpfung beim Abkühlen von einer Erstarrungstemperatur der Schutzmasse (21) auf eine Betriebstemperatur des Sensors (4).

4. Sensor (4) nach einem der vorstehenden Ansprüche, wobei wenigstens ein Teil der Oberfläche des Schaltungsgehäuses (20) im Kontaktbereich mit der Schutzmasse (21) aktiviert ist.

5. Sensor (4) nach einem der vorstehenden Ansprüche, wobei wenigstens ein Teil der Oberfläche des Schaltungsgehäuses (20) im Kontaktbereich mit der Schutzmasse (21) aufgeraut ist.

6. Sensor nach Anspruch 5, wobei der aufgeraute Teil der Oberfläche des Schaltungsgehäuses (20) mit einem Laser aufgeraut ist.

7. Verfahren zur Herstellung eines Sensors (4) zum Ausgeben eines elektrischen Signals basierend auf einer erfassten physikalischen Größe, umfassend die Schritte:
- Einhausen einer Messschaltung (6, 10), die über einen elektrischen Signalanschluss (8) mit einer externen Schaltung (12) kontaktierbar ist, in einem Schaltungsgehäuse (20), wobei das Schaltungsgehäuse auf seiner Oberfläche mindestens zwei umfänglich um das Schaltungsgehäuse verlaufende Rippen (28) aufweist,
- Einhausen des Schaltungsgehäuses (20) mit einer Schutzmasse (21), deren Ausdehnungskoeffizient größer ist als ein Ausdehnungskoeffizient des Schaltungsgehäuses (20).

8. Verfahren nach Anspruch 7, **gekennzeichnet durch** den Schritt:
- Aufrauen wenigstens eines Teils der Oberfläche des Schaltungsgehäuses (20), insbesondere mit einem Laser.

9. Verfahren nach Anspruch 7 oder 8, **dadurch gekennzeichnet, dass** die Schutzmasse wenigstens im Bereich der aufgerauten Oberfläche aufgebracht wird.

## Claims

1. Sensor (4) for outputting an electrical signal on the basis of a detected physical variable, comprising:
- a measuring circuit (6, 10) which is accommodated in a circuit housing (20) and with which an external circuit (12) can make contact by means of an electrical signal connection (8), and
- a protective body which surrounds the circuit housing (20) and is composed of a protective compound (21) and has an opening (22) by means of which a portion of the circuit housing (20) is exposed,
- wherein the circuit housing (20) has, on its surface, at least two ribs (28) which run around the periphery of the circuit housing (20) and are surrounded by the protective compound (21), and
- wherein the protective compound (21) has a coefficient of expansion which is greater than a coefficient of expansion of the circuit housing (20).

2. Sensor (4) according to Claim 1, wherein a wall (38) of the ribs (28) has a pitch angle (42) in relation to the surface (40) of the circuit housing (20) in a range of between 70° and 88°.

3. Sensor (4) according to one of the preceding claims, wherein the protective compound (21) can be sprayed or molded around the circuit housing (20), wherein the shrinkage of said protective compound during curing after spraying or molding is selected to be less than shrinkage during cooling from a solidification temperature of the protective compound (21) to an operating temperature of the sensor (4).

4. Sensor (4) according to one of the preceding claims, wherein at least a portion of the surface of the circuit housing (20) is activated in the region of contact with the protective compound (21).

5. Sensor (4) according to one of the preceding claims, wherein at least a portion of the surface of the circuit housing (20) is roughened in the region of contact with the protective compound (21).

6. Sensor according to Claim 5, wherein the roughened portion of the surface of the circuit housing (20) is roughened using a laser.

7. Method for producing a sensor (4) for outputting an electrical signal on the basis of a detected physical variable, comprising the steps of:
- accommodating a measuring circuit (6, 10), with which an external circuit (12) can make contact by means of an electrical signal connection (8), in a circuit housing (20), wherein the circuit housing has, on its surface, at least two ribs (28) which run around the periphery of the circuit housing,
- accommodating the circuit housing (20) with a protective compound (21) whose coefficient of expansion is greater than a coefficient of expansion of the circuit housing (20).

8. Method according to Claim 7, **characterized by** the step of:
- roughening at least a portion of the surface of the circuit housing (20), in particular using a laser.

9. Method according to claim 7 or 8, **characterized in that** the protective compound is applied at least in the region of the roughened surface.

## Revendications

1. Capteur (4) destiné à délivrer un signal électrique en se basant sur une grandeur physique acquise, comprenant :
- un circuit de mesure (6, 10) qui est logé dans un boîtier de circuit (20) et qui peut être mis en contact avec un circuit externe (12) par le biais d'une borne de signal électrique (8), et
- un corps de protection entourant le boîtier de circuit (20), constitué d'une masse de protection (21) et muni d'une ouverture (22) par le biais de laquelle une partie du boîtier de circuit (20) est libérée,
- le boîtier de circuit (20) possédant sur sa surface au moins deux nervures (28) qui s'étendent de manière circonférentielle autour du boîtier de circuit (20), lesquelles sont entourées par la masse de protection (21), et
- la masse de protection (21) possédant un coefficient de dilatation qui est supérieur à un coefficient de dilatation du boîtier de circuit (20).

2. Capteur (4) selon la revendication 1, une paroi (38) des nervures (28) possédant un angle d'inclinaison (42) compris dans une plage entre 70° et 88° par rapport à la surface (40) du boîtier de circuit (20).

3. Capteur (4) selon l'une des revendications précédentes, la masse de protection (21) pouvant être appliquée par pulvérisation ou moulée autour du boîtier de circuit (20), sa rétraction lors du durcissement après la pulvérisation ou le moulage étant choisie plus petite qu'une rétraction lors du refroidissement d'une température de solidification de la masse de protection (21) à une température de service du capteur (4).

4. Capteur (4) selon l'une des revendications précédentes, au moins une partie de la surface du boîtier de circuit (20) dans la zone de contact avec la masse de protection (21) étant activée.

5. Capteur (4) selon l'une des revendications précédentes, au moins une partie de la surface du boîtier de circuit (20) dans la zone de contact avec la masse de protection (21) étant rendue rugueuse.

6. Capteur selon la revendication 5, la partie rendue rugueuse de la surface du boîtier de circuit (20) étant rendue rugueuse avec un laser.

7. Procédé de fabrication d'un capteur (4) destiné à délivrer un signal électrique en se basant sur une grandeur physique acquise, comprenant les étapes suivantes :
- logement d'un circuit de mesure (6, 10), lequel peut être mis en contact avec un circuit externe (12) par le biais d'une borne de signal électrique (8), dans un boîtier de circuit (20), le boîtier de circuit possédant sur sa surface au moins deux nervures (28) qui s'étendent de manière circonférentielle autour du boîtier de circuit,
- logement du boîtier de circuit (20) dans une masse de protection (21) dont le coefficient de dilatation est supérieur à un coefficient de dilatation du boîtier de circuit (20).

8. Procédé selon la revendication 7, **caractérisé par** l'étape consistant à rendre rugueuse au moins une partie de la surface du boîtier de circuit (20), notamment avec un laser.

9. Procédé selon la revendication 7 ou 8, **caractérisé en ce que** la masse de protection est appliquée au moins dans la zone de la surface rendue rugueuse.
